# EUROPÄISCHE PATENTSCHRIFT

(11) **EP 0 405 408 B1**
(45) Veröffentlichungstag und Bekanntmachung des Hinweises auf die Patenterteilung: **11.01.1995**
(21) Anmeldenummer: 90112053.5
(22) Anmeldetag: 25.06.1990
(51) Int. Cl.: H05K 3/34

(54) **Verfahren und Vorrichtung zum Kontaktieren von Bauelementen mittels Laserstrahlen**
Method and apparatus of making contact to a semiconductor component by use as a laser beam, and resulting device
Procédé et dispositif pour fabriquer un contact pour composants semi-conducteurs par un laser

(30) Priorität: 29.06.1989 DE 3921426
(43) Veröffentlichungstag der Anmeldung: 02.01.1991
(73) Patentinhaber: Siemens Nixdorf Informationssysteme Aktiengesellschaft, 33102 Paderborn (DE)
(72) Erfinder: Berghammer, Johannes, Dr. Tech., D-8013 Haar (DE); Laussermair, Thomas, Dr. Inf., D-8034 Germering (DE); Rüdesheim, Thomas, Dipl.-Inf., D-8256 Lengdorf (DE)
(74) Vertreter: Fuchs, Franz-Josef, Dr.-Ing.

(56) Entgegenhaltungen:
- EP-A- 0 364 962
- DD-A- 251 868
- DE-A- 3 701 013
- US-A- 3 632 955
- US-A- 4 327 277
- US-A- 4 682 001

## Beschreibung

Die Erfindung betrifft ein Verfahren und eine Vorrichtung zum Kontaktieren von Bauelementen der Mikroelektronik mittels Laserstrahlen.

Mit zunehmender Miniaturisierung der mikroelektronischen Bauteile sind auch die Anforderungen an die Präzision einer Kontaktierung dieser Bauteile erheblich gestiegen. Inzwischen gibt es neben dem Standardverfahren des Wellenlötens mehrere Varianten des Reflow-Lötens, das als Grundtechnik zum Kontaktieren von oberflächenmontierbaren Bauteilen angesehen werden kann.

Eine erste Variante des Reflow-Lötens ist das Infrarot-Löten, bei dem eine Flachbaugruppe z.B. mit einem Quarzstrahler solange erwärmt wird, bis das Kontaktmaterial an den Kontaktstellen der Bauteile schmilzt. Mit den auf dem Markt befindlichen Infrarot-Lötanlagen können zeitliche Temperaturprofile, allerdings ohne genaue räumliche Differenzierung erzielt werden.

Eine weitere Variante des Reflow-Lötens ist das Dampfphasenlöten, bei dem eine Flachbaugruppe mit heißem Dampf beaufschlagt wird und durch Kondensation eine räumlich gleichmäßige Erwärmung der Flachbaugruppe erreicht wird. Das zeitliche Temperaturprofil ist dabei allerdings nicht steuerbar. Anlagen für das Dampfphasenlöten müssen mit einer Abschirmung für die verwendeten giftigen Gase versehen sein.

Eine weitere Variante des Reflow-Lötens ist das Laser-Löten von dem eine erste Untervariante das sogenannte sequentielle Laser-Löten aus dem US-Patent No. 4 327 277 bekannt ist. Bei dieser Löttechnik ist als Wärmequelle ein Hochleistungs-Gaslaser vorgesehen, der in sehr kurzer Zeit hintereinander einzelne Lötstellen erwärmt. Das dadurch notwendige sequentielle Positionieren auf den zu erwärmenden Lötstellen geschieht durch bausteinweises Verfahren der Flachbaugruppe und anschlußbezogenes Ablenken des Laserstrahles. Dazu sind die Daten für die Bestückungsgeometrie der Flachbaugruppe erforderlich.

Eine Energieeinsparung und Beschleunigung bei diesem Verfahren ist, wie aus der deutschen Patentschrift DE 37 01 013 bekannt, durch Infrarot-Pyrometrie und individuelles Terminieren des Aufheizvorganges möglich.

Eine weitere Untervariante des Laser-Lötens stellt das sogenannte bausteinparallele Laser-Löten dar. Gegenüber dem sequentiellen Laser-Lötverfahren wird bei dem bausteinparallelen Laser-Löten der Primärstrahl eines Gaslasers in mehrere Sekundärstrahlen zum bausteinparallelen Löten aufgespaltet. Die von der Bausteingeometrie abhängige Aufspaltung des Laserstrahls kann inflexibel, wie aus dem US-Patent 3 632 955 bekannt ist, durch Verwendung fester Linsen oder flexibel, wie aus dem US-Patent 4 682 001 bekannt durch Zwischenschalten und entsprechendes Verschieben von Infrarotlicht-leitenden Glasfasern erreicht werden.

Jedes der obengenannten Verfahren bringt eine Reihe spezifischer Probleme mit sich. Beim Infrarot-Löten mit Quarzstrahlern gibt es keine genaue räumliche Differenzierung der Wärmebestrahlung. Beim Dampfphasenverfahren ist der Temperaturschock, dem die Bauteile ausgesetzt sind unerwünscht und zudem sind die bei diesem Verfahren erforderlichen umweltgefährdenden Stoffe kritisch in ihrer Handhabung. Gegenüber dem Wellen- und Infrarot-Löten bietet das Laser-Löten grundsätzlich neue Möglichkeiten. In Anbetracht der zunehmenden hohen Packungsdichte von Bauelementen auf einer Flachbaugruppe erfordert das sequentielle Laser-Löten durch die Fülle von Daten für die Bestückungsgeometrie und die erforderliche Positioniergenauigkeit einen hohen zeitlichen Aufwand. Außerdem wird die zur Erwärmung einer Lötstelle erforderliche Energie in einem einzigen Einstrahlvorgang aufgebracht, was unter Umständen zu einer explosionsartigen Verdampfung des Lotes führen kann.

Die Aufgabe der vorliegenden Erfindung ist es daher ein Verfahren zum Kontaktieren von Bauelementen der Mikroelektronik anzugeben, bei dem mehrere Stellen gleichzeitig, jeweils für sich individuell erwärmt werden können, und für das eine Kenntnis der Bestückungsgeometrie nicht notwendig ist.

Gelöst wird die Aufgabe erfindungsgemäß durch die im Anspruch 1 angegebenen Merkmale.

Vorteilhafte Weiterbildungen der Erfindung sind in den Ansprüchen 2 bis 6 angegeben.

Eine Vorrichtung zum Kontaktieren von Bauelementen nach dem erfindungsgemäßen Verfahren sowie vorteilhafte Weiterbildungen dieser Vorrichtung sind in den Ansprüchen 7 bis 9 angegeben.

Mit der nach der Erdindung ausgebildeten Vorrichtung können Flachbaugruppen nach dem Reflow-Prinzip durch einen mehrschrittigen Aufheiz- und Meßvorgang räumlich und zeitlich geregelt erwärmt werden. Die Regelung ermöglicht für jede Stelle dar Flachbaugruppe unabhängig von der Bestückungsgeometrie eine einheitliche Temperaturerhöhung mit einem vorgebbaren Aufheizverlauf. Dazu durchfließen die eventuell schon in geringem Maße vorgeheizten Flachbaugruppen einen Heizbereich mit einer Vielzahl von längs und quer zur Transportrichtung ausgerichteten fein auflösenden Laserstrahlen. Ein individuelles Positionieren der Flachbaugruppe ist vorteilhafterweise nicht erforderlich. Ausserdem läßt sich eine nach diesem erfindungsgemäßen Verfahren arbeitende Vorrichtung leicht in eine bestehende Fließfertigung integrieren.

Anhand der Zeichnung wird im folgenden ein Ausführungsbeispiel der Erfindung näher erläutert.

Dabei zeigen
- FIG 1: eine symbolische Darstellung einzelner Verfahrensschritte bei der Kontaktierung innerhalb einer Prozeßlinie,
- FIG 2 a: einen prinzipiellen Aufbau einer erfindungsgemäßen Vorrichtung mit einer Infrarotkamera und einer Darstellung ihres Meßbereiches,

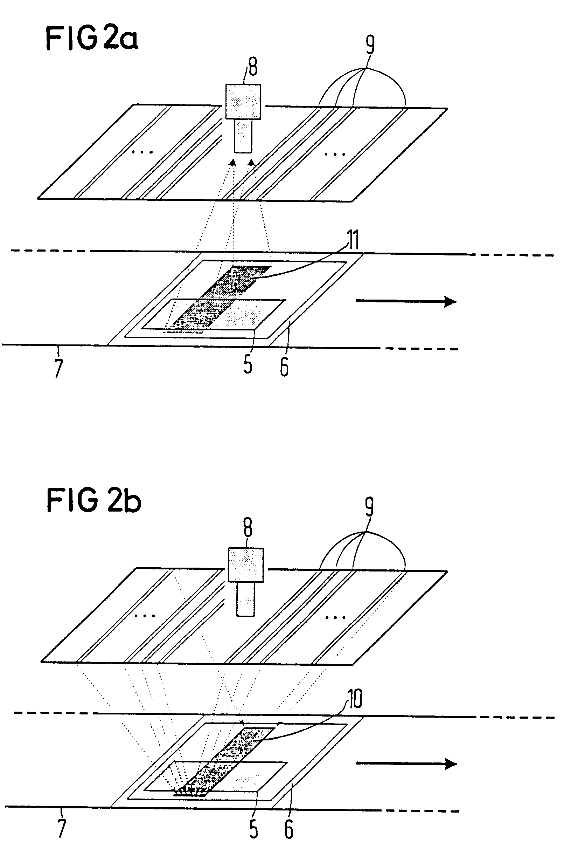

- FIG 2 b: einen prinzipiellen Aufbau einer erfindungsgemäßen Vorrichtung mit Laserstrahlen und einer Darstellung ihres Heizbereiches,

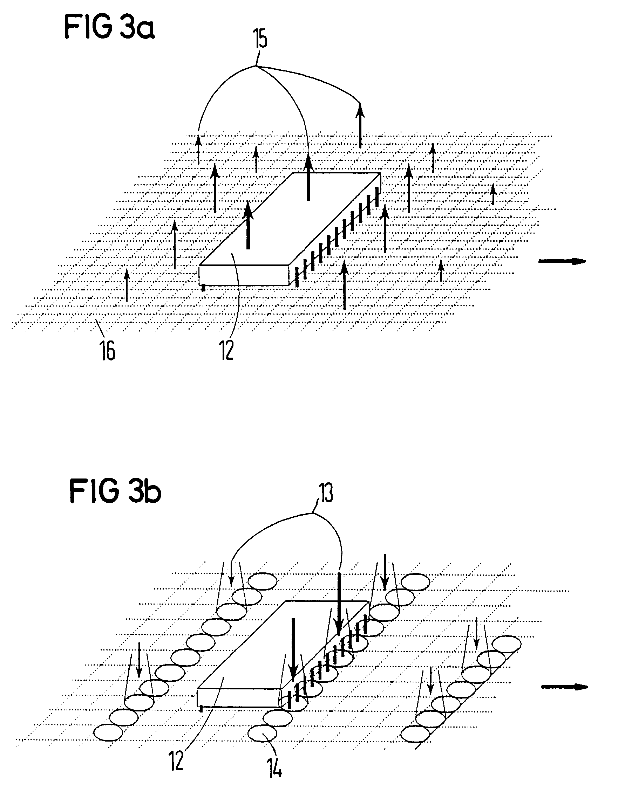

- FIG 3 a: einen schematischen Ausschnitt einer Flachbaugruppe im Heizbereich und einer Darstellung der lokal unterschiedlichen Infrarot-Abstrahlung von der Flachbaugruppenoberfläche,
- FIG 3 b: einen schematischen Ausschnitt einer Flachbaugruppe im Heizbereich und einer Darstellung der lokal unterschiedlichen Infrarotbestrahlung durch die Laserstrahlen,

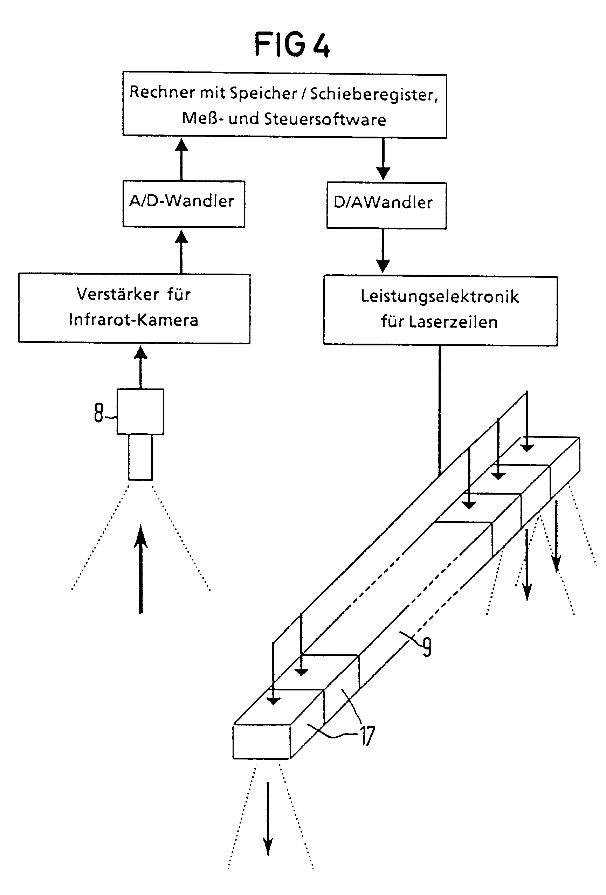

- FIG 4: ein Blockschaltbild zur Darstellung eines Datenflusses für eine Regelung der Laserstrahlen.

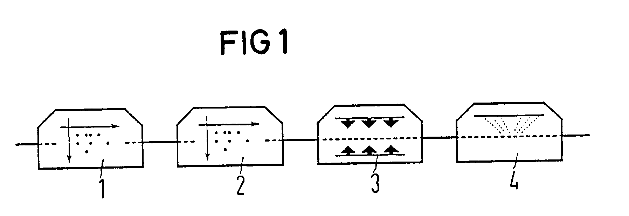

In FIG 1 sind hintereinander vier Stationen einer Prozeßlinie symbolisch dargestellt. In einer Klebestation 1 und Bestückstation 2 werden Flachbaugruppen mit SMD-Bauteilen bestückt. Anschließend durchlaufen die Flachbaugruppen einen gewöhnlichen Vorheizofen 3 z.B. einen Infrarot-Quarzstrahlofen und werden durch gleichmäßige Bestrahlung auf eine Temperatur unterhalb des eutektischen Punktes vorgewärmt. Unmittelbar danach durchlaufen die Flachbaugruppen dann eine Infrarot-Löseranlage 4 mit Temperaturregelung gemäß der vorliegenden Erfindung.

Die FIG 2 a und 2 b zeigen jeweils in schematischer Darstellung eine erfindungsgemäß ausgebildete Vorrichtung zum Kontaktieren von Bauelementen der Mikroelektronik. Eine Flachbaugruppe 5 ist in einem Werkstückträger 6 fixiert und liegt auf einer Transportvorrichtung 7. Die Transportvorrichtung 7 bewegt den Werkstückträger 6 und damit die Flachbaugruppe 5 in eine durch einen Pfeil angedeutete Transportrichtung. In einer parallelen Ebene zur Flachbaugruppe befindet sich in starrer Anordnung eine Vielzahl von Laserdioden, die zeilen- und spaltenweise angeordnet sind, wobei jede Zeile quer zur Transportrichtung und jede Spalte in Transportrichtung ausgerichtet ist. Ebenfalls in starrer Anordnung oberhalb der Transportvorrichtung 7 ist eine pyrometrische Kamera 8 installiert.

Für die folgende Betrachtung ist es von Vorteil, sich eine Flachbaugruppe 5 aus einzelnen jeweils sehr schmalen quer zur Transportrichtung verlaufenden Zeilen zusammengesetzt vorzustellen. Ein wesentliches Merkmal dieser Ausführungsform der Erfindung ist nämlich die bildpunktförmige, räumlich sehr differenzierte, zeilenweise parallele Bestrahlung der Flachbaugruppe durch Infrarotlaserstrahlen. Diese sind zu diesem Zweck in aus Halbleiter-Laserdioden bestehende Laserstrahlzeilen 9 zusammengefaßt. Die Projektion all dieser Laserstrahlzeilen auf einen sogenannten Heizbereich 10 stellt eine Abfolge von eng benachbarten parallelen Streifen dar, welche von jeder einzelnen Flachbaugruppenzeile sequentiell durchlaufen werden. Die Laserstrahlzeilen 9 sind dabei so ausgerichtet, daß ihre Projektionen im Heizbereich 10 so kurze Abstände haben, daß ein deutliches Abkühlen zwischen den Einstrahlvorgängen während des Transports der Flachbaugruppe verhindert wird.

Die räumliche Auflösung der Flachbaugruppe 5 in Transportrichtung wird durch den kontinuierlichen Transport durch den Heizbereich 10, die räumliche Auflösung quer zur Transportrichtung durch eine parallele Anordnung mehrerer Einzellaserstrahlen je Laserstrahlzeile erzielt.

Die FIG 3 a und 3 b zeigen in schematischer Darstellung die unterschiedlich starke Infrarotabstrahlung 15 von der Flachbaugruppe 16 und die unterschiedliche Strahlenergie der Laserstrahlen innerhalb einer Laserstrahlenzeile.

Um etwa die Auflösung der Kontaktanschlüsse eines SMD-Bausteins 12 zu gewährleisten beträgt die von einem einzelnen Laserstrahl bedeckte Fläche 14 auf der Flachbaugruppenoberfläche etwa 2 x 2 mm² Bei einer maximalen Breite der Flachbaugruppe von 500 mm ergeben sich daraus ca. 250 Halbleiterlaser je Laserstrahlenzeile. Eine Infrarotkamera mit z.B. 512 x 512 Bildpunkten liefert eine Flächenauflösung von etwa 1 x 1 mm² der Flachbaugruppe im Meßbereich 11 für eine pyrometrische Rückkopplung.

Beim Eintritt in den Heizbereich wird die Temperatur der unmittelbar vor der ersten Laserstrahlzeile befindlichen Flachbaugruppenzeile abgetastet und in einem Schieberegister mit der Breite entsprechend der Laserstrahlzeilenauflösung gespeichert. Wegen des unterschiedlichen Emissionsverhaltens der Flachbaugruppenoberfläche sieht das Infrarotbild selbst bei annähernd gleicher Temperatur inhomogen aus. Das Regelziel besteht im Erreichen eines um einen vorgebbaren Temperatur-Differenzwert verschobenen Infrarotbildes. Eine Auswerteeinrichtung, z.B. ein Steuerrechner, muß für einen gleichmäßigen Temperaturhub an jeder Einzelposition der Flachbaugruppe (Bildpunkt) sorgen. Wegen der unterschiedlichen Reflexions- und Absorptionseigenschaften der Flachbaugruppenoberfläche erfordert dies aber das Einstrahlen von lokal unterschiedlichen Infrarotleistungen 13. Durch die feine Auflösung innerhalb der Laserstrahlzeilen und durch die Vielzahl der Zeilen selbst läßt sich durch ständige Temperaturmessung ein zeitlicher Aufwärmverlauf für jede Einzelposition auf der Flachbaugruppe vorgeben.

Die FIG 4 zeigt ein Blockschaltbild für den Datenfluß von der Infrarotkamera 8 über die Auswerteeinrichtung bzw. den Steuerrechner zur Bemessung der Strahlenergie der einzelnen Laserstrahlen.

Der Steuerrechner vergleicht für jede im Heizbereich befindliche Flachbaugruppenzeile simultan nach dem Pipelineprinzip die gemessene Temperatur mit der sich aus dem vorgegebenen Wunschprofil der Aufwärmung und dem im Schieberegister gespeicherten Wert ergebenden Solltemperatur. Anhand dieses Soll-Ist-Vergleichs wird die Leistung der Einzellaserstrahlen in der jeweils positionsmäßig nachfolgenden Laserstrahlzeile entsprechend dimensioniert.

Ein besonderer Vorteil der Erfindung ist die Tatsache, daß die zum Reflowlöten erforderliche Wärmeenergie nicht wie beim bekannten sequentiellen Laserlöten durch nur einen, sondern summarisch über mehrere sequentielle Einstrahlvorgänge bereitgestellt wird. Der oben beschriebene Einstrahl- und simultane Meßvorgang wird für jede Flachbaugruppe im Heizbereich, abhängig von der Anzahl vorgesehener Laserzeilen pro zu erwärmende Stelle etwa 10 bis 20 mal (entsprechend der Anzahl der Zeilen) wiederholt. Somit können durch erhöhte Strahlungsenergie Temperaturschwankungen lokal ausgeglichen werden und gleichzeitig ein definierter Temperaturverlauf unabhängig von der Bestückung erzielt werden.

Der Steuerrechner übernimmt dabei die zeitliche Koordinierung der Leistung der etwa 250 als Halbleiterlaser ausgebildeten Laserquellen einer Zeile mit den von der Infrarotkamera stammenden Meßdaten simultan für alle Laserstrahlzeilen. Die Geschwindigkeit der Transportvorrichtung und die Anzahl der Laserstrahlen pro bestrahlte Fläche bestimmen dabei die erforderlichen Übertragungsraten für die Bildabtastfrequenz, die Schaltfrequenz des Steuerrechners sowie für die Kamera und Leistungssteuerung.

Die Auswerteeinrichtung bzw. der Steuerrechner kann in einer Weiterbildung der Erfindung für zusätzliche Funktionen verwendet werden. Liegen die Daten der Bestückungsgeometrie und damit die Position der einzelnen Lötstellen, z.B. in einem CAD-System vor, kann das Einstrahlen nur auf diese Positionen beschränkt werden. Damit reduziert man die thermische Belastung der Bauteile und spart Energie, man wird dabei aber wieder von der Bestückungsgeometrie der Flachbaugruppe abhängig. Alternativ kann man auch über ein Bildverarbeitungssystem einzelne Bauteile erkennen und dann entsprechend der Bauteilgeometrie selektiv löten. Die dadurch erzielte Unabhängigkeit von der Bestückungsgeometrie der Flachbaugruppe erfordert jedoch einen wesentlichen höheren datentechnischen Aufwand.

Bei Kenntnis der Position der Bauteile und einzelner Lötstellen ist es darüber hinaus mit Hilfe der Erfindung möglich, bestimmte Bereiche der Flachbaugruppenoberfläche mit unterschiedlichem Profil des Aufheizverlaufes zu erwärmen und dadurch ein optimales Reflowlötergebnis zu erzielen.

## Patentansprüche

1. Verfahren zum Kontaktieren von Bauelementen der Mikroelektronik mit einer Vielzahl von Laserquellen (9), deren Laserstrahlen (13,15) auf die Oberseite einer mittels einer Transporteinrichtung (7) in horizontaler Richtung beförderten Trägerfläche der Bauelemente nebeneinander so auftreffen, daß sich jeweils ein erster und wenigstens ein zweiter Laserstrahl in Transportrichtung hintereinander befinden, durch stellenindividuelles Erwärmen mittels Laserstrahlen (13,15), bei dem jede zur Erwärmung vorgesehene Stelle jeweils in einem ersten und danach wenigstens noch in einem zweiten Meßschritt pyrometrisch bewertet und ein jeweils ermittelter Wärmewert an eine Auswerteeinrichtung weitergeleitet wird und bei dem die jeweilige Stelle nach jedem Meßschritt für eine Zeitspanne mit jeweils wenigstens einem Laserstrahl beaufschlagt wird, dessen Strahlenergie von der Auswerteeinrichtung dabei jeweils so eingestellt wird, daß sich die jeweilige Stelle nach einem vorgebbaren Aufwärmverlauf allmählich erwärmt und mit Ablauf der einem letzten Meßschritt folgenden Zeitspanne einen Wärmewert erreicht, der gegenüber dem im ersten Schritt ermittelten Wärmewert um einen vorgebbaren Differenzwert erhöht ist.

2. Verfahren nach Anspruch 1, **dadurch gekennzeichnet**, daß eine jeweilige Stelle nach jedem Meßschritt von wenigstens einem, ausschließlich dem jeweiligen Meßschritt zugeordneten Laserstrahl beaufschlagt wird.

3. Verfahren nach Anspruch 2, **dadurch gekennzeichnet**, daß gleichzeitig wenigstens eine weitere Stelle von dem bzw. den einem vorhergehenden und/oder nachfolgenden Meßschritt zugeordneten Laserstrahl bzw. Laserstrahlen beaufschlagt wird.

4. Verfahren nach einem der Ansprüche 1 bis 3, **dadurch gekennzeichnet**, daß jedem Meßschritt mehrere, jeweils eine Stelle beaufschlagenden Laserstrahlen zugeordnet sind.

5. Verfahren nach einem der Ansprüche 1 bis 4, **dadurch** **gekennzeichnet**, daß der Auswerteeinrichtung Daten zur Identifikation der zu erwärmenden Stellen zugeführt werden.

6. Verfahren nach Anspruch 5, **dadurch ge****kennzeichnet**, daß die Daten von einem bildvearbeitenden System ermittelt werden.

7. Vorrichtung zum Kontaktieren von Bauelementen der Mikroelektronik mit einer Vielzahl von Laserquellen (9), deren Laserstrahlen (13,15) auf die Oberseite einer mittels einer Transporteinrichtung (7) in horizontaler Richtung beförderten Trägerfläche der Bauelemente nebeneinander so auftreffen, daß sich jeweils ein erster und wenigstens ein zweiter Laserstrahl in Transportrichtung hintereinander befinden, mit einer Infrarotkamera (8) zur gleichzeitigen pyrometrischen Wärmewerterfassung der den auftreffenden Laserstrahlen (13,15) in Transportrichtung vorgelagerten Stellen und mit einer mit der Infrarotkamera (8) und jeder Laserquelle (9) verbundenen Auswerteeinrichtung zum individuellen und zeitabhängigen Einstellen der Strahlenergie einer jeden Laserquelle (9).

8. Vorrichtung nach Anspruch 7, **dadurch gekennzeichnet**, daß die Laserstrahlen bei ihrem Auftreffen zeilen- und spaltenweise angeordnet sind und daß jede Zeile quer zur Transportrichtung und jede Spalte in Transportrichtung ausgerichtet ist.

9. Vorrichtung nach Anspruch 7 oder 8, **dadurch** **gekennzeichnet**, daß die Laserquellen als Halbleiterlaser ausgebildet sind.

## Claims

1. Method for bonding microelectronic components by means of a multiplicity of laser sources (9) whose laser beams (13, 15) impinge side by side on the upper side of a support surface, conveyed in the horizontal direction by means of a transporting device (7), of the components in such a manner that in the direction of transport in each case a first laser beam and at least one second laser beam are located one behind the other, by individually heating the points by means of laser beams (13, 15), in which each point intended for heating is pyrometrically evaluated in each case in a first measuring step and thereafter at least also in a second measuring step and a respectively determined heat value is routed to an evaluation unit and in which, after each measuring step, for a period of time, the respective point is exposed to in each case at least one laser beam whose radiation energy is in each case adjusted by the evaluation unit in such a manner that the respective point is gradually heated according to a predeterminable heating curve and, after the period of time which follows a last measuring step has expired, reaches a heat value which is higher by a predeterminable differential value with respect to the heat value determined in the first step.

2. Method according to Claim 1, characterized in that after each measuring step a respective point is exposed to at least one laser beam which is assigned exclusively to the respective measuring step.

3. Method according to Claim 2, characterized in that at the same time at least a further point is exposed to the laser beam or laser beams assigned to a preceding and/or subsequent measuring step.

4. Method according to one of Claims 1 to 3, characterized in that a plurality of laser beams, in each case acting on one point, are assigned to each measuring step.

5. Method according to one of Claims 1 to 4, characterized in that data for identifying the points to be heated are fed to the evaluation unit.

6. Method according to Claim 5, characterized in that the data are determined by an image-processing system.

7. Device for bonding microelectronic components by means of a multiplicity of laser sources (9) whose laser beams (13, 15) impinge side by side on the upper side of a support surface, conveyed in the horizontal direction by means of a transporting device (7), of the components in such a manner that in the direction of transport in each case a first laser beam and at least one second laser beam are located one behind the other, having an infrared camera (8) for simultaneously pyrometrically measuring the heat values of the points which in the direction of transport are located in front of the impinging laser beams (13, 15), and having an evaluation unit, connected to the infrared camera (8) and each laser source (9), for the individual and time-dependent adjustment of the radiation energy of each laser source (9).

8. Device according to Claim 7, characterized in that the laser beams, when impinging, are arranged in rows and columns and in that each row is aligned transversely to the direction of transport and each column is aligned in the direction of transport.

9. Device according to Claim 7 or 8, characterized in that the laser sources are constructed as semi-conductor lasers.

## Revendications

1. Procédé pour établir un contact entre des composants de la microélectronique et une multiplicité de sources laser (9), dont les faisceaux lasers (13,15) rencontrent côte-à-côte la face supérieure d'une surface de support des composants, entraînée dans la direction horizontale au moyen d'un dispositif de transport (7), de sorte que respectivement un premier faisceau laser et au moins un second faisceau laser se trouvent l'un derrière l'autre dans la direction de transport, par chauffage en des emplacements individuels au moyen de faisceaux lasers (13,15), dans lequel chaque emplacement destiné à être chauffé est évalué par voie pyrométrique lors d'une première étape de mesure et, ensuite, au moins à nouveau dans une deuxième étape de mesure, et une valeur thermique déterminée est transmise à un dispositif d'évaluation, et dans lequel l'emplacement respectif est appliqué pendant un intervalle de temps, après chaque étape de mesure, au moins un faisceau laser, dont l'énergie de rayonnement est réglée respectivement par le dispositif d'évaluation de telle sorte que l'emplacement soit chauffé peu à peu conformément à un profil de chauffage pouvant être prédéterminé et, au fur et à mesure que s'écoule l'intervalle de temps qui succède à une dernière étape de mesure, atteigne une valeur thermique, qui est accrue d'une valeur de différence pouvant être prédéterminée, par rapport à la valeur thermique déterminée lors de la première étape.

2. Procédé suivant la revendication 1, caractérisé par le fait qu'à un emplacement est appliqué, après chaque étape de mesure, au moins un faisceau laser associé exclusivement à cette étape de mesure.

3. Procédé suivant la revendication 2, caractérisé par le fait que simultanément est appliqué à au moins un autre emplacement le ou les faisceaux lasers associés à une étape de mesure précédente et/ou suivante.

4. Procédé suivant l'une des revendications 1 à 3, caractérisé par le fait que plusieurs faisceaux lasers appliqués chacun à un emplacement, sont associés à chaque étape de mesure.

5. Procédé suivant l'une des revendications 1 à 4, caractérisé par le fait que des données destinées à l'identification des emplacements devant être chauffés sont envoyées au dispositif d'évaluation.

6. Procédé suivant la revendication 5, caractérisé par le fait que les données sont déterminées par un système de traitement d'images.

7. Dispositif pour établir un contact entre des composants de la microélectronique et une multiplicité de sources laser (9), dont les faisceaux lasers (13,15) rencontrent côte-à-côte la face supérieure d'une surface de support des composants, entraînée dans la direction horizontale au moyen d'un dispositif de transport (7), de sorte qu'un premier faisceau laser et au moins un deuxième faisceau laser se trouvent situés l'un derrière l'autre dans la direction de transport, comportant une caméra infrarouge (8) destinés à la détection pyrométrique simultanée de valeurs thermiques des emplacements disposés en amont des faisceaux lasers incidents (13,15) dans la direction de transport, et un dispositif d'évaluation relié à la caméra à infrarouge (8) et à chaque source laser (9) et destiné à régler individuellement et en fonction du temps l'énergie du faisceau de chaque source laser (9).

8. Dispositif suivant la revendication 7, caractérisé par le fait que les faisceaux lasers sont disposés, lors de leur impact, suivant des lignes et des colonnes et que chaque ligne s'étend transversalement par rapport à la direction de transport et que chaque colonne s'étend dans la direction de transport.

9. Dispositif suivant la revendication 7 ou 8, caractérisé par le fait que les sources lasers ont la forme de lasers à semiconducteurs.
